# EUROPEAN PATENT APPLICATION

(11) **EP 2 548 909 A1**
(43) Date of publication of application: **23.01.2013**
(21) Application number: 10847663.1
(22) Date of filing: 15.03.2010
(51) Int. Cl.: C08G 73/06, C09K 11/06, H01L 51/00

(54) **CYCLOPENTADIENEDITHIOPHENE-QUINOXALINE CONJUGATED POLYMER AND PREPARATION METHOD AND USES THEREOF**

(71) Applicant: Ocean's King Lighting Science&Technology Co., Ltd., Guangdong 518054 (CN)
(72) Inventor: ZHOU, Mingjie, Guangdong 518054 (CN); HUANG, Jie, Guangdong 518054 (CN); XU, Erjian, Guangdong 518054 (CN)
(74) Representative: Brunetti, Fabrizio
(86) International application number: PCT/CN2010/071053
(87) International publication number: WO 2011/113194

(57) **Abstract**

A cyclopentadienedithiophene-quinoxaline conjugated polymer and a preparation method and uses thereof are disclosed. The preparation method comprises the following steps: reacting diketone compound with o-phenylenediamine compound to obtain dibromide intermediate of quinoxaline heteroarylic ring compound; carrying out Stille-type coupling reaction of the intermediate, with 2,6-di(trimethyltin)-4,4-dialkyl-cyclopentadiene[2,1-b:3,4-b'] dithiophene compound, and 2,6-dibromo-4,4-dialkyl-cyclopentadiene[2,1-b:3,4-b'] dithiophene compound to obtain the cyclopentadienedithiophene-quinoxaline conjugated polymers. The polymers may be used in the fields of polymer solar cell and the like due to good solubility, high carrier mobility and relatively strong modifiability of chemical property and chemical structure. The preparation method is simple and can be handled and controlled easily.

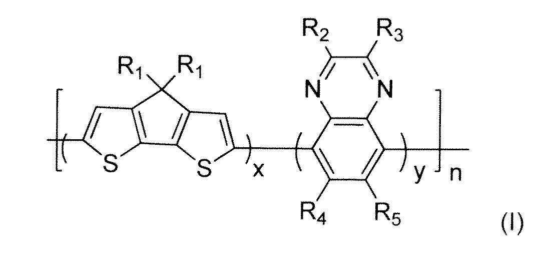

## Description

### Field of the invention

The present invention belongs to the technical field of organic synthesis, and particularly relates to a cyclopentadienedithiophene-quinoxaline conjugated polymer, and preparation method and uses thereof.

### Background of the invention

It has long been a focus and difficulty in the photovoltaic field to manufacture low-cost and high-efficacy solar cells from cheap raw materials. Current silicon solar cells for ground use are limited in their applications due to the complex manufacturing processes and high costs. In order to lower the cost and expand the application scope, persistent efforts have been made to pursue new materials for solar cells. Polymeric solar cells have drawn great attention due to the low prices of the raw materials, light weight, flexibility, simple manufacturing processes, and the possibility for large-scale production by coating, printing, and the like. If their energy transfer efficiency can be increased to near the level of commercial silicon solar cells, their market prospects may be very broad. Since 1992 when N. S. Sariciftci et al. reported the photo-induced electron transfer between conjugated polymers and C₆₀, a great deal of research has been conducted in polymeric solar cells, and a rapid progress has been made. Currently, the research on polymeric solar cells is mainly focused on donor-receptor blend systems, and the energy transfer efficiency for PCPDTBT-PCBM blend system has reached 6.5%. However, it is still much lower than that for inorganic solar cells. The main factors hindering the improvement of the performance include: relatively low carrier mobility of organic semi-conductive devices, incompatibility between the spectral response of the devices and the solar radiation spectrum, low efficiency in utilizing infra-red region which has high photon flux, low electrode collection rate of the carriers, and the like. In order to achieve practical applications of the polymeric solar cells, the most important task in this research field is to develop new materials and to significantly increase its energy transfer efficiency.

### Summary of the invention

Accordingly, the present invention provides a cyclopentadienedithiophene-quinoxaline conjugated polymer, which has good solubility, high carrier mobility, and relatively strong chemical and structural modifiability.

The present invention further provides a method for preparing the cyclopentadienedithiophene-quinoxaline conjugated polymer which is simply, easy to be operated and controlled, and suitable for industrial production.

The examples of the present invention further provide uses of the cyclopentadienedithiophene-quinoxaline conjugated polymer in fields such as polymeric solar cells, organic electroluminescence, organic field-effect transistors, organic optical storage, organic non-linear materials, and/or organic laser.

A cyclopentadienedithiophene-quinoxaline conjugated polymer, having the following general formula (I):

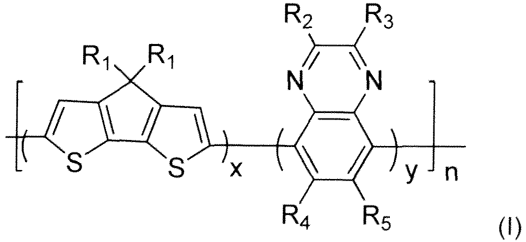

Wherein, x + y = 1, 0.5 ≤ x <1, n is a positive integer of 100 or less, R₁ is C₁∼C₂₀ alkyl; R₂, R₃, R₄, R₅ are the same or different and are each hydrogen atom, C₁∼C₂₀ alkyl or alkoxy, fluorenyl containing alkyl, pyrrolyl containing alkyl, or phenyl containing alkyl.

A method for preparing a cyclopentadienedithiophene-quinoxaline conjugated polymer, comprising the following steps:
reacting a diketone compound with an o-phenylenediamine compound in an organic acid solution to obtain a dibromo quinoxaline heteroarylic ring;
conducting a Stille coupling reaction of the dibromo quinoxaline heteroarylic ring with 4,4-dialkyl-2,6-bis(trimethyltin)-cyclopentadiene(2,1-b:3,4-b')dithiophene compound and 4,4-dialkyl-2,6-dibromo-cyclopentadiene (2,1-b:3,4-b')dithiophene compound to obtain the cyclopentadienedithiophene- quinoxaline conjugated polymer.

Uses of the cyclopentadienedithiophene-quinoxaline conjugated polymer in fields such as polymeric solar cells, organic electroluminescence, organic field-effect transistors, organic optical storage, organic non-linear materials and/or organic laser.

The above technical solutions provide the following advantages.
1. The polymer contains the structural unit of cyclopentadiene dithiophene or a derivative thereof, in which the two thiophene rings are in the same plane, which effectively expands the conjugation of the polymer, and lowers the energy gap thereof. In addition, this kind of co-planer structure makes the transfer of the carriers between the two main chains easier, thereby increasing the carrier mobility.
2. The polymer contains the quinoxaline unit, imparting the polymer with high electron transfer performance, high glass transition temperature, and excellent electrochemical reduction properties. In addition, as a good receptor unit with strong electron-withdrawing power, the quinoxaline unit imparts the polymer of the present invention with relatively strong chemical and structural modifiability. Furthermore, electron-donating groups and electron-accepting groups can be introduced with simple methods to regulate the electron-withdrawing property of the polymer.
3. By introducing long alkyl chains into the cyclopentadienedithiophene-quinoxaline conjugated polymer, the solubility and processability of the material are effectively improved, expanding its application scope in fields such as polymeric solar cells.
4. The preparation of the polymer is carried out in an appropriate reaction environment from a small number of reactants. The reaction proceeds by controlling the temperature to obtain the target product. Accordingly, the method is simply, easy to be operated and controlled, and suitable for industrial production.
5. During the process of utilizing the polymer as an active material in fields such as polymeric solar cells, organic electroluminescence, organic field-effect transistors, organic optical storage, organic non-linear materials and/or organic laser, a high-temperature treatment is conducted to effectively increase the orderliness and regularity of the alignment of various groups within the molecules and of various molecular chains in the material, thereby improving the transfer rate and efficiency of the carrier mobility, and further effectively improving the photoelectric conversion efficiency of the device.

### Brief Description of the Drawings

The present invention will be described in detail in combination with the figures and Examples, in which:
Figure 1 is a structural scheme of a polymeric solar cell device employing poly[4,4-dioctyl-cyclopentadiene(2,1-b:3,4-b')dithiophene-co-2,3-di(phenyl)quinox aline] of the Example of the present invention as the active layer;
Figure 2 is a structural scheme of an organic electroluminescent device employing poly[4,4-dioctyl-cyclopentadiene(2,1-b:3,4-b')dithiophene-co-2,3-di(phenyl)quinoxaline] of the Example of the present invention; and
Figure 3 is a structural scheme of an organic field-effect transistor employing poly[4,4-dioctyl-cyclopentadiene(2,1-b:3,4-b)dithiophene-co-2,3-di(phenyl)quinox alpine] of the Example of the present invention.

### Detailed Description of the preferred Embodiments

In order to make the technical problem to be solved by the present invention, the technical solutions, and the advantageous effects more obvious, the present invention will be described in detail in combination with the Examples. It shall be appreciated that the specific Examples described herein are only for illustration of the present invention and shall not be construed to limit the present invention.

An embodiment of the present invention provides a cyclopentadiene dithiophene-quinoxaline conjugated polymer, having the following general formula (I) : 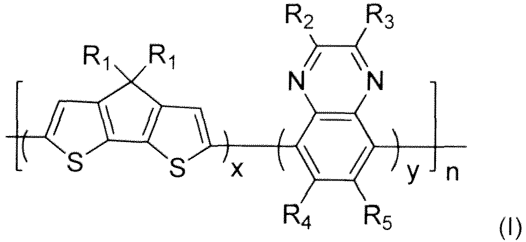 wherein, x + y = 1, 0.5 ≤ x <1, n is a positive integer of 100 or less, R₁ is C₁∼C₂₀ alkyl; R₂, R₃, R₄, R₅ are the same or different and are each hydrogen atom, C₁∼C₂₀ alkyl or alkoxy, fluorenyl containing alkyl, pyrrolyl containing alkyl, or phenyl containing alkyl.

The above fluorenyl containing alkyl is preferably a group represented by the following formula (A), wherein R₇ and R₈ are each C₁-C₂₀ alkyl, and wherein the phenyl ring in the fluorenyl containing alkyl may be optionally substituted at any available position,

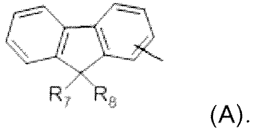

The pyrrolyl containing alkyl is preferably a group represented by the following formula (B), wherein Rg is C₁-C₂₀ alkyl, and wherein the phenyl ring in the pyrrolyl unit may be optionally substituted at any available position,

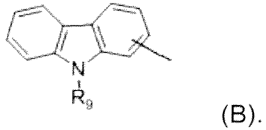

The phenyl containing alkyl is preferably a group represented by the following formula (C), wherein R₁₀ is C₁∼C₂₀ alkyl, and R₁₀ may be at any available position on the phenyl ring,

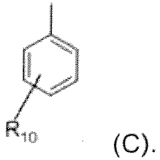

The polymer in the embodiments of the present invention contains the structural unit of cyclopentadiene dithiophene or a derivative thereof, in which the two thiophene rings are in the same plane, which effectively expands the conjugation of the polymer, and lowers the energy gap thereof. In addition, this kind of co-planer structure makes the transfer of carriers between the two main chains easier, thereby increasing the carrier mobility. For example, the carrier mobility for a copolymer of cyclopentadiene(2,1-b:3,4-b')dithiophene with benzothiadiazole (PCPDTBT) reaches 2 x 10⁻² cm²V⁻¹.s⁻¹ even without optimization. Accordingly, the polymers containing a cyclopentadiene dithiophene structural unit, such as cyclopentadiene(2,1-b:3,4-b')dithiophene structural unit, have important application prospects in fields such as organic solar cells.

The polymer in the embodiments of the present invention also contains the quinoxaline unit, imparting the polymer with high electron transfer performance, high glass transition temperature, and excellent electrochemical reduction properties. In addition, as a good receptor unit with strong electron-withdrawing power, the quinoxaline unit imparts the polymer of the present invention with relatively strong chemical and structural modifiability. Furthermore, electron-donating groups and electron-accepting groups can be introduced with simple methods to regulate the electron-withdrawing property of the polymer, expanding its applications in organic photoelectric material fields. Furthermore, in a preferred embodiment, long alkyl chains or alkoxy chains, for exmple, R₁∼R₉ are C₁∼C₂₀ alkyl or alkoxy, are introduced into the cyclopentadienedithiophene-quinoxaline conjugated polymer, effectively improving the solubility and processability of the material, and expanding its application scope in fields such as polymeric solar cells.

The method for preparing the cyclopentadienedithiophene-quinoxaline conjugated polymer provided in an embodiment of the present invention is as follows:

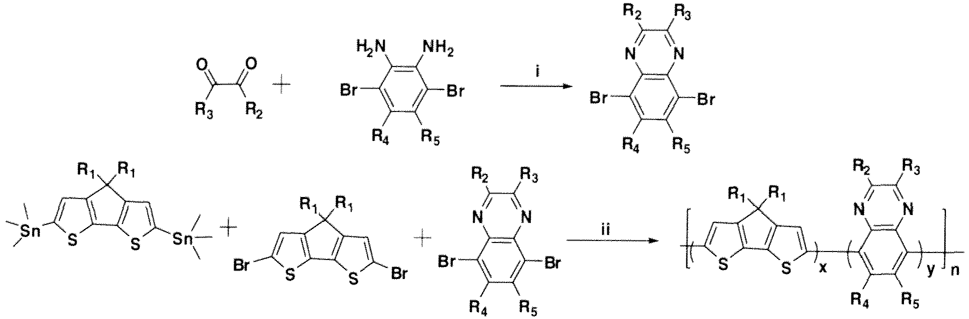

The specific steps in this method are:
Step i: reacting a diketone compound with an o-phenylenediamine compound in an organic solvent to obtain a dibromo quinoxaline heteroarylic ring;
Step ii: Conducting a Stille coupling reaction of the dibromo quinoxaline heteroarylic ring with 4,4-dialkyl-2,6-bis(trimethyltin)-cyclopentadiene (2,1-b:3,4-b')dithiophene compound and 4,4-dialkyl-2,6-dibromo-cyclopentadiene (2,1-b:3,4-b')dithiophene compound to obtain the cyclopentadienedithiophene-quinoxaline conjugated polymer.

The preparation of the dibromo quinoxaline heteroarylic ring (i.e. Step i) comprises adding the diketone compound and the o-phenylenediamine compound into the organic solvent at a molar ratio of 1 : 0.1~10, and reacting at 20°C~120°C for 1~24 h. In step i, the minimum amount of the organic solvent shall be sufficient to ensure the dissolution of the reactants. Provided that the minimum amount is met, the specific amount of the organic solvent may be flexibly changed as appropriate. The organic solvent is preferably acetic acid, m-cresol, methanol, ethanol or butanol, more preferably acetic acid.

The above Stille coupling reaction (i.e. Step ii) comprises adding 4,4-dialkyl-2,6-bis(trimethyltin)-cyclopentadiene(2,1-b:3,4-b')dithiophene, 4,4-dialkyl-2,6-dibromo-cyclopentadiene(2,1-b:3,4-b')dithiophene and the dibromo quinoxaline heteroarylic ring into an organic solvent at a molar ratio of 1 : 1-100 : 1, and conducting the Stille coupling reaction at 50°C∼150°C for 24-72 h. In step ii, the minimum amount of the organic solvent shall be sufficient to ensure the dissolution of the reactants. Provided that the minimum amount is met, the specific amount of the organic solvent may be flexibly changed as appropriate. The organic solvent is preferably at least one of tetrahydrofuran, ethylene glycol dimethyl ether, benzene, and toluene. If the reaction time for the Stille coupling reaction is too short, the molecular weight of the copolymer is low or even no polymerization occurs. However, if the reaction time is too long, the molecular weight of the copolymer tends to be constant and no longer increases. In addition, the longer the reaction time, the higher the energy consumption, and the higher the preparation cost. Accordingly, the reaction time is preferably 24∼72 h.

A catalyst may be added to the above Stille coupling reaction to increase the coupling reaction rate and the yield of the target copolymer. The catalyst may be an organic palladium catalyst or a mixture of an organic palladium catalyst and an organic phosphine ligand, and the amount thereof is 0.05 ∼ 50% by molar based on the amount of 4,4-dialkyl-2,6-bis(trimethyltin)-cyclopentadiene(2,1-b:3,4-b')dithiophene. The organic palladium catalyst may be at least one of Pd₂(dba)₃/P(o-Tol)₃, Pd(PPh₃)₄ and Pd(PPh₃)₂Cl₂; and the molar ratio in the mixture of the organic palladium catalyst and the organic phosphine ligand is 1 : 2-20.

The preparation of the dibromo quinoxaline heteroarylic ring and/or the preparation of the cyclopentadienedithiophene-quinoxaline conjugated polymer may be carried out in the presence or absence of oxygen, but preferably in the absence of oxygen. The absence of oxygen may be achieved by vacuum or by charging with an inert gas, preferably by charging with an inert gas. The inert gas may be a commonly used inert gas in the art, such as nitrogen, argon, and the like, preferably nitrogen. The object of preferably carrying out the reaction in the absence of oxygen is to increase the yields for the two steps, as oxygen is an active material which would react with the reactants, interfere with the reaction, and thereby lower the yield of each step.

In the embodiments of the present invention, the preparation of the polymer is carried out in an appropriate reaction environment from a small number of reactants, and the reaction proceeds by controlling the temperature to obtain the target product. Accordingly, the method is simply, easy to be operated and controlled, and suitable for industrial production.

After a high-temperature treatment of the copolymer of the present invention, the orderliness and regularity of the alignment of various groups within the molecules and of various molecular chains in the material are effectively increased, thereby improving the transfer rate and efficiency of the carrier mobility, and further effectively improving the photoelectric conversion efficiency of the device.

Accordingly, the cyclopentadienedithiophene-quinoxaline conjugated polymer of the present invention can be used in fields such as organic photoelectric materials, polymeric solar cells, organic electroluminescence, organic field-effect transistors, organic optical storage, organic non-linear materials and/or organic laser as an active material.

The present invention will now be described in more details with the preparations of specific polymers as examples.

### Example 1: Preparation of poly[4,4-dioctyl-cyclopentadiene(2,1-b:3,4-b')dithiophene-co-2,3-di(phenyl)quinox aline]:

Under the protection of nitrogen, 3.7 mmol (1.0 g) 3,6-dibromo-o-phenylenediamine and 1.84 mmol (0.39 g) diphenylethanedione are added into 20 mL acetic acid. After refluxing at 120 °C for 1 hour, the reaction solution is poured into water, neutralized with sodium bicarbonate, and extracted with chloroform. The organic phase is washed with saturated saline, dried over anhydrous sodium sulfate, and rotary evaporated to remove the solvent. The crude product is purified with column chromatography to give a white solid, which is recrystallized with chloroform/n-hexane to give a white solid, i.e. 5,8-dibromo-2,3-di(phenyl)quinoxaline, yield: 81%. MS (EI) m/z: 440(M⁺).

Under the protection of nitrogen, 0.5 mmol (0.22 g) 5,8-dibromo-2,3-di(phenyl)quinoxaline, 0.5 mmol (0.356 g) 4,4-dioctyl-2,6-bis(trimethyltin)-cyclopentadiene(2,1-b:3,4-b')dithiophene, 0.5 mmol 4,4-dialkyl-2,6-dibromo-cyclopentadiene(2,1-b:3,4-b')dithiophene are added into 30 mL toluene, and bubbled for 0.5 h to remove oxygen from the reaction environment. Then, 0.015 mol (0.014 g) Pd₂(dba)₃ and 0.027 mmol (0.0083 g)P(o-Tol)₃ are added, and bubbled for further 1 h to remove oxygen from the reaction environment. The reaction mixture is heated to 50°C to reflux for 72 hours. After reaction, the reaction mixture is added into methanol for precipitation, and filtered. The obtained solid is washed with methanol, dried, re-dissolved with chlorobenzene, and added into an aqueous solution of sodium diethyldithio carbamate. The reaction mixture is then heated to 80°C and stirred for 12 hours. The organic phase is purified with alumina column chromatography and eluted with chlorobenzene. The organic solvent is removed under reduced pressure, and the resulted mixture is added into methanol for precipitation, and filtered to give a solid. The obtained solid is extracted by a Soxhelt for 72 hours with acetone. The resulted mixture is added into methanol for precipitation, and filtered under suction overnight with a vacuum pump to give a solid with a yield of 53%. GPC: Mn = 39500, PDI = 2.3.

### Example 2: Preparation of poly[4,4-dioctyl-cyclopentadiene(2,1-b:3,4-b')dithiophene-co-2,3-di(phenyl)quinox aline]:

Under the protection of nitrogen, 0.184mmol (0.050 g) 3,6-dibromo-o-phenylenediamine and 1.84 mmol (0.39 g) diphenylethanedione are added into 20 mL 1 : 1 (v/v) mixed solvent of m-cresol and methanol. After refluxing at 80°C for 12 hours, the reaction solution is poured into water, neutralized with sodium bicarbonate, and extracted with chloroform. The organic phase is washed with saturated saline, dried over anhydrous sodium sulfate, and rotary evaporated to remove the solvent. The crude product is purified with column chromatography to give a white solid, which is recrystallized with chloroform/n-hexane to give a white solid, i.e. 5,8-dibromo-2,3-di(phenyl)quinoxaline, yield: 93%. MS (EI) m/z: 480(M⁺).

0.5 mmol (0.22 g) 5,8-dibromo-2,3-di(phenyl)quinoxaline, 0.5 mmol (0.356 g) 4,4-dioctyl-2,6-bis(trimethyltin)-cyclopentadiene(2,1-b:3,4-b')dithiophene, 50 mmol 4,4-dialkyl-2,6-dibromo-cydopentadiene(2,1-b:3,4-b')dithiophene are added into 50 mL of a mixed organic solvent of ethylene glycol dimethyl ether and tetrahydrofuran (1 : 1, v/v), and bubbled for 0.8 h to remove oxygen from the reaction environment. Then, 0.025 mmol Pd(PPh₃)₄ is added, and bubbled for further 1 h to remove oxygen from the reaction environment. The reaction mixture is heated to 150 °C to reflux for 24 hours. After reaction, the reaction mixture is added into methanol for precipitation, and filtered. The obtained solid is washed with methanol, dried, re-dissolved with chlorobenzene, and added into an aqueous solution of sodium diethyldithio carbamate. The reaction mixture is then heated to 80°C and stirred for 12 hours. The organic phase is purified with alumina column chromatography and eluted with chlorobenzene. The organic solvent is removed under reduced pressure, and the resulted mixture is added into methanol for precipitation, and filtered to give a solid. The obtained solid is extracted by a Soxhelt for 72 hours with acetone. The resulted mixture is added into methanol for precipitation, and filtered under suction overnight with a vacuum pump to give a solid with a yield of 41 %. GPC: Mn = 39300, PDI = 2.2.

### Example 3: Preparation of poly[4,4-dioctyl-cyclopentadiene(2,1-b:3,4-b')dithiophene-co-2,3-di(phenyl)quinox aline]:

18.4 mmol (4.973 g) 3,6-dibromo-o-phenylenediamine and 1.84 mmol (0.39 g) diphenylethanedione are added into 20 mL butanol. After refluxing at 20 °C for 24 hours, the the reaction solution is poured into water, neutralized with sodium bicarbonate, and extracted with chloroform. The organic phase is washed with saturated saline, dried over anhydrous sodium sulfate, and rotary evaporated to remove the solvent. The crude product is purified with column chromatography to give a white solid, which is recrystallized with chloroform/n-hexane to give a white solid, i.e. 5,8-dibromo-2,3-di(phenyl)quinoxaline, yield: 74%. MS (EI) m/z- 410(M⁺).

Under the protection of nitrogen, 0.5 mmol (0.22 g) 5,8-dibromo-2,3-di(phenyl) quinoxaline, 0.5 mmol (0.356 g) 4,4-dioctyl-2,6-bis(trimethyltin)-cyclopentadiene (2,1-b:3,4-b')dithiophene, 25 mmol 4,4-dialkyl-2,6-dibromo-cyclopentadiene (2,1-b:3,4-b')dithiophene are added into 40 mL of an aqueous solution of tetrahydrofuran, and bubbled for 0.8 h to remove oxygen from the reaction environment. Then, 12.5 mmol Pd(PPh₃)₂Cl₂ is added, and bubbled for further 1 h to remove oxygen from the reaction environment. The reaction mixture is heated to 100°C to reflux for 36 hours. After reaction, the reaction mixture is added into methanol for precipitation, and filtered. The obtained solid is washed with methanol, dried, re-dissolved with chlorobenzene, and added into an aqueous solution of sodium diethyldithio carbamate. The reaction mixture is then heated to 80°C and stirred for 12 hours. The organic phase is purified with alumina column chromatography and eluted with chlorobenzene. The organic solvent is removed under reduced pressure, and the resulted mixture is added into methanol for precipitation, and filtered to give a solid. The obtained solid is extracted by a Soxhelt for 72 hours with acetone. The resulted mixture is added into methanol for precipitation, and filtered under suction overnight with a vacuum pump to give a solid with a yield of 49%. GPC: Mn = 39470, PDI = 2.3.

### Application Example 4: Application of poly[4,4-dioctyl-cyclopentadiene(2,1-b:3,4-b')dithiophene-co-2,3-di(phenyl)quinox aline] in a solar cell device as an active layer:

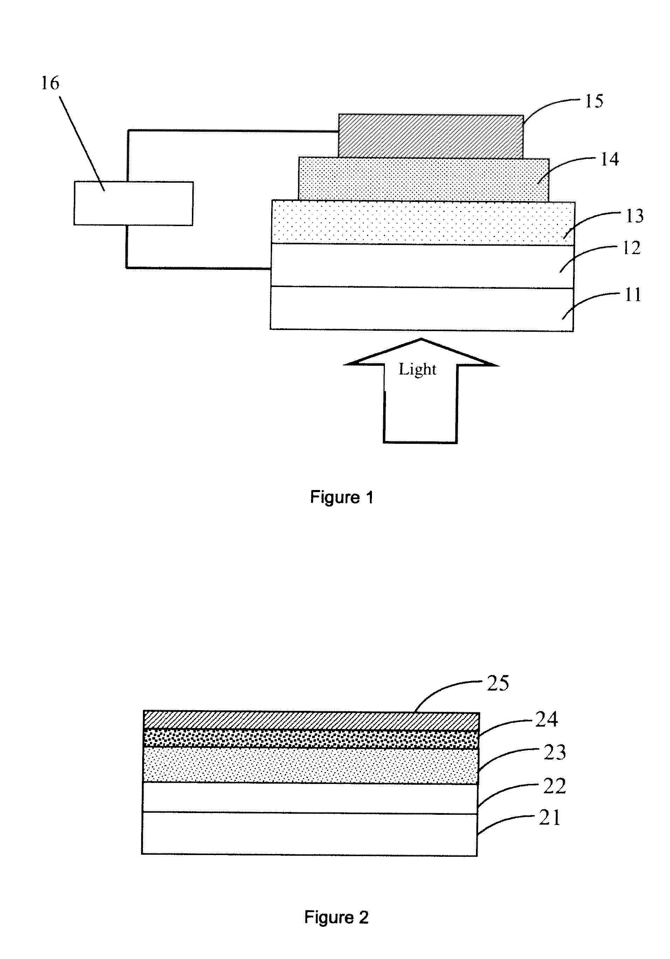

The structure of the solar cell device is shown in Figure 1.

The active layer material comprises poly[4,4-dioctyl-cyclopentadiene (2,1-b:3,4-b')dithiophene-co-2,3-di(phenyl)quinoxaline] of the present invention as an electron-donating material, and [6,6]phenyl-C₆₁-butyric acid methyl ester (PCBM) as an electron-accepting material. In other words, the device sequentially comprises a glass layer 11, an ITO layer 12, a PEDOT:PSS layer 13, a copolymer active layer 14 and a metal layer 15, wherein ITO is indium tin oxide with a square resistance of 10-20 Ω/sq, PEDOT is polyethylenedioxythiophene, and PSS is polystyrenesulfonate. The glass layer 11 coated with ITO layer 12 is firstly sonicated, followed by oxygen-Plasma treatment. Then, the PEDOT:PSS layer 13 is coated on the ITO layer. Then, melt-blended poly[4,4-dioctyl-cyclopentadiene (2,1-b:3,4-b')dithiophene-co-2,3-di(phenyl)quinoxaline] of the present invention and PCBM are coated on the surface of the PEDOT:PSS to form the copolymer active layer 14. The metal Al is deposited on the active layer with vacuum evaporation to form the metal layer 15. The metal layer 15 is used as the cathode, and the ITO layer 12 is used as the anode, to give the organic solar cell device comprising the polymer of the present Example. After thermal treatment of the device, the chemical structure of the material becomes more orderly, which increases the transfer rate and efficiency of the carriers, and improves the photoelectric conversion efficiency of the device.

### Application Example 5: Application of poly[4,4-dioctyl-cyclopentadiene(2,1-b:3,4-b')dithiophene-co-2,3-di(phenyl)quinox aline] in a solar cell device as an active layer:

Referring to Figure 1 which shows a solar cell device employing the poly[4,4-dioctyl-cyclopentadiene(2,1-b:3,4-b')dithiophene-co-2,3-di(phenyl)quinox aline] of the above Example, sequentially comprising a glass substrate 11, a transparent anode 12, an intermediate auxiliary layer 13, an active layer 14, and a cathode 15 which are laminated together, wherein the intermediate auxiliary layer 13 is polyethylenedioxythiophene : polystyrenesulfonate composite (PEDOT:PSS), the active layer 14 comprises electron-donator material and electron-acceptor material, wherein the electron-donator material is the above 4,4-dioctyl-cyclopentadiene(2,1-b:3,4-b')dithiophene-2,3-di(phenyl)quinoxaline, and the electron-acceptor material is [6,6]phenyl-C₆₁-butyric acid methyl ester (PCBM). The transparent anode 12 may be indium tin oxide (ITO), preferably indium tin oxide with a square resistance of 10-20 Ω/sq. The cathode 15 may be Al electrode or bimetallic layer electrode, such as Ca/Al, Ba/Al, or the like. The glass substrate 11 is used as the base layer. In the process of manufacturing, ITO glass is selected and sonicated, followed by oxygen-Plasma treatment. The intermediate auxiliary layer 13 is coated on the ITO glass. Then, blended poly[4,4-dioctyl-cyclopentadiene(2,1-b:3,4-b')dithiophene-co-2,3-di(phenyl)quinox aline] and electron-acceptor material are coated on the intermediate auxiliary layer 13 to form the active layer 14. The cathode 15 is then deposited on the active layer 14 with vacuum evaporation to form the solar cell device. In a preferred example, the thicknesses of the transparent anode 12, the intermediate auxiliary layer 13, the active layer 14, and the bimetal layers Ca and Al are 160 nm, 40 nm, 150 nm, 20 nm, 70 nm, respectively.

As shown in Figure 1, under light irradiation, the light passes through the glass substrate 11 and the ITO electrode 12, and poly[4,4-dioctyl-cyclopentadiene (2,1-b:3,4-b')dithiophene-co-2,3-di(phenyl)quinoxaline] in the active layer 14 absorbs the energy of the light to produce excitons, which migrate to the interface of the electron-donator/electron-acceptor materials, and transfer electrons to the electron-acceptor material, e.g. PCBM, to achieve the separation of charges, thereby producing free carriers, i.e. free electrons and holes. These free electrons are transferred to the metal cathode along the electron-acceptor material and collected by the cathode, and the free holes are transferred to the ITO anode along the electron-donator material and collected by the anode, thereby forming photocurrent and photovoltage, and achieving photoelectric conversion. When an external load 16 is connected, it can be powered. In this process, poly[4,4-dioctyl-cyclopentadiene(2,1-b:3,4-b')dithiophene-co-2,3-di(phenyl)quinoxaline], due to its broad spectral response range, may utilize the light energy more sufficiently, to achieve higher photoelectric conversion efficiency, and improve the ability of the solar cell device to produce electric power. In addition, the mass of the solar cell device may be lowered by using this kind of organic material, and the manufacturing of the solar cell device may be conducted by spin coating or the like, which facilitates large-scale production.

### Application Example 6: Application of poly[4,4-dioctyl-cyclopentadiene(2,1-b:3,4-b')dithiophene-co-2,3-di(phenyl)quinox aline] in an organic electroluminescence device:

Referring to Figure 2 which shows an organic electroluminescent device employing the poly[4,4-dioctyl-cyclopentadiene(2,1-b:3,4-b')dithiophene-co-2, di(phenyl)quinoxaline] of the above Example, sequentially comprising a glass substrate 21, a transparent anode 22, a luminous layer 23, a buffer layer 24 and a cathode 25 which are laminated together. The transparent anode 22 may be indium tin oxide (ITO), preferably indium tin oxide with a square resistance of 10-20 Ω/sq. The luminous layer 23 comprises poly[4,4-dioctyl-cyclopentadiene(2,1-b:3,4-b')dithiophene-co-2,3-di(phenyl)quinox aline] of the above Example. The buffer layer 24 may be LiF or the like, but is not limited thereto. The cathode 25 may be, but is not limited to metal Al, Ba or the like. Accordingly, in a specific example, the structure of the organic electroluminescence devices is expresses as: ITO / poly[4,4-dioctyl-cyclopentadiene(2,1-b:3,4-b')dithiophene-co-2,3-di(phenyl)quinoxaline] / LiF / Al. Each layer may be formed by know processes, and poly[4,4-dioctyl-cyclopentadiene(2,1-b:3,4-b')dithiophene-co-2,3-di(phenyl)quinox aline] may be formed on the ITO with spin coating.

### Application Example 7: Application of poly[4,4-dioctyl-cyclopentadiene(2,1-b:3,4-b')dithiophene-co-2,3-di(phenyl)quinox aline] in an organic field-effect transistor:

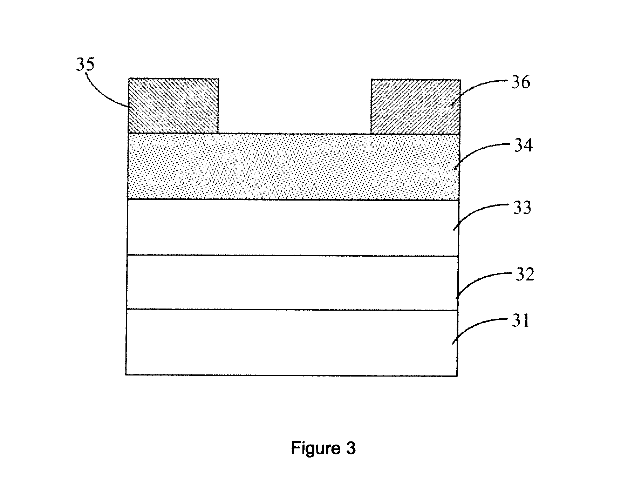

Referring to Figure 3 which shows an organic field-effect transistor employing the poly[4,4-dioctyl-cyclopentadiene(2,1-b:3,4-b')dithiophene-2,3-di(phenyl) quinoxaline] of the above Example, sequentially comprising a substrate 31, an insulating layer 32, a modifying layer 33, an organic semi-conductor layer 34 and a source electrode 35 and a drain electrode 36 disposed on the organic semi-conductor layer 34, which are laminated together. The substrate 31 may be, but is not limited to, highly doped silicon chip (Si), and the insulating layer 32 may be, but is not limited to, SiO₂ with a thickness of nano-meter scale (e.g. 450 nm). The organic semi-conductor layer 34 may be the above poly[4,4-dioctyl-cyclopentadiene(2,1-b:3,4-b')dithiophene-co-2,3-di(phenyl)quinox aline]. The source electrode 35 and the drain electrode 36 may both be, but is not limited to, gold. The modifying layer 33 may be, but is not limited to, octadecyltrichlorosilane. The substrate 31, the insulating layer 32, the modifying layer 33 and the source electrode 35 and the drain electrode 36 may be formed by know processes. The organic semi-conductor layer 34 may be formed by spin coating the poly[4,4-dioctyl-cyclopentadiene(2,1-b:3,4-b)dithiophene-co-2,3-di(phenyl)quinoxaline] of the above Example on the insulating layer 32 modified by the modifying layer 33.

The above Examples are preferred embodiments of the present invention, and shall not be construed as limiting the present invention. All the amendments, equivalent substitutions and improvements made within the spirit and principles of the present invention shall be encompassed in the scope of protection of the present invention.

## Claims

1. A cyclopentadienedithiophene-quinoxaline conjugated polymer, having the following general formula (I): 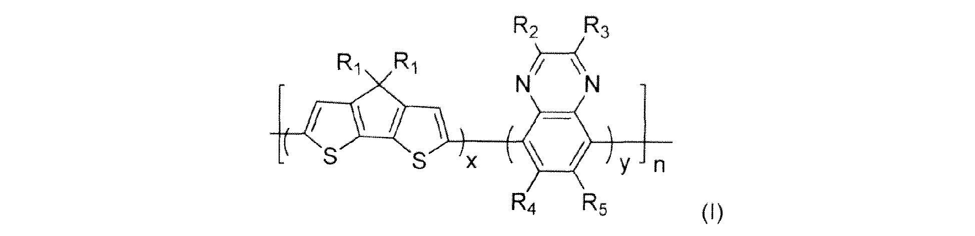 wherein, x + y = 1, 0.5 ≤ x <1, n is a positive integer of 100 or less, R₁ is C₁∼C₂₀ alkyl; R₂, R₃, R₄, R₅ are the same or different and are each hydrogen atom, C₁∼C₂₀ alkyl or alkoxy, fluorenyl containing alkyl, pyrrolyl containing alkyl, or phenyl containing alkyl.

2. The cyclopentadienedithiophene-quinoxaline conjugated polymer according to Claim 1, wherein:
the fluorenyl containing alkyl is represented by the following formula (A), wherein R₇ and R₈ are each C₁∼C₂₀ alkyl, 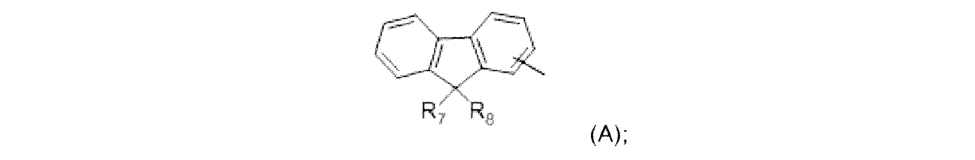
the pyrrolyl containing alkyl is represented by the following formula (B), wherein R₉ is C₁∼C₂₀ alkyl, 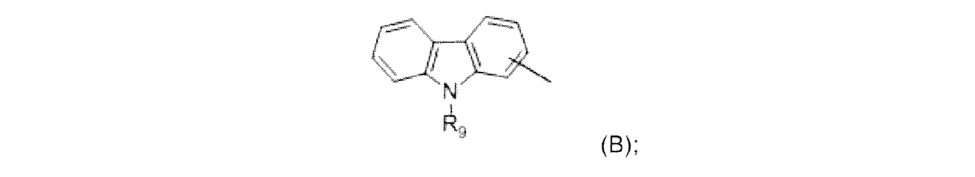
the phenyl containing alkyl is represented by the following formula (C), wherein R₁₀ is C₁∼C₂₀ alkyl,

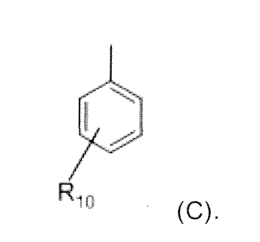

3. A method for preparing a cyclopentadienedithiophene-quinoxaline conjugated polymer, comprising the following steps:
reacting a diketone compound with an o-phenylenediamine compound in an organic acid solvent to obtain a dibromo quinoxaline heteroarylic ring;
conducting a Stille coupling reaction of the dibromo quinoxaline heteroarylic ring with 4,4-dialkyl-2,6-bis(trimethyltin)-cyclopentadiene(2,1-b:3,4-b')dithiophene compound and 4,4-dialkyl-2,6-dibromo-cyclopentadiene (2,1-b:3,4-b')dithiophene compound to obtain the cyclopentadienedithiophene-quinoxaline conjugated polymer.

4. The method for preparing the cyclopentadienedithiophene-quinoxaline conjugated polymer according to Claim 3, wherein the step for preparing the dibromo quinoxaline heteroarylic ring and/or the stille coupling reaction step are carried out in the absence of oxygen.

5. The method for preparing the cyclopentadienedithiophene-quinoxaline conjugated polymer according to Claim 3, wherein the preparing of the dibromo quinoxaline heteroarylic ring comprises adding the diketone compound and the o-phenylenediamine compound into the organic solvent at a molar ratio of 1 : 0.1∼10, and reacting at 20°C∼120°C for 1∼24 h; and
the organic solvent is at least one of acetic acid, m-cresol, methanol, ethanol or butanol.

6. The method for preparing the cyclopentadienedithiophene-quinoxaline conjugated polymer according to Claim 3, wherein the stille coupling reaction comprises adding 4,4-dialkyl-2,6-bis(trimethyltin)-cyclopentadiene(2,1-b:3,4-b')dithiophene, 4,4-dialkyl-2,6-dibromo-cyclopentadiene(2,1-b:3,4-b')dithiophene and the dibromo quinoxaline heteroarylic ring into an organic solvent at a molar ratio of 1 : 1∼100 : 1, and reacting at 50°C∼150°C for 24∼72 h; and the organic solvent is at least one of tetrahydrofuran, ethylene glycol dimethyl ether, benzene, and toluene.

7. The method for preparing the cyclopentadienedithiophene-quinoxaline conjugated polymer according to Claim 3, wherein a catalyst is added to the stille coupling reaction, the catalyst being an organic palladium catalyst or a mixture of an organic palladium catalyst and an organic phosphine ligand, and the amount of the catalyst is 0.05 ∼ 50% by molar based on the amount of 4,4-dialkyl-2,6-bis(trimethyltin)-cyclopentadiene(2,1-b:3,4-b')dithiophene.

8. The method for preparing the cyclopentadienedithiophene-quinoxaline conjugated polymer according to Claim 7, wherein the organic palladium catalyst is Pd₂(dba)₃/P(o-Tol)₃, Pd(PPh₃)₄ or Pd(PPh₃)₂Cl₂.

9. The method for preparing the cyclopentadienedithiophene-quinoxaline conjugated polymer according to Claim 8, wherein the molar ratio in the mixture of the organic palladium catalyst and the organic phosphine ligand is 1 : 2-20.

10. Use of the cyclopentadienedithiophene-quinoxaline conjugated polymer according to Claim 1 in organic photoelectric materials, polymeric solar cells, organic electroluminescent devices, organic field-effect transistors, organic optical storage devices, organic non-linear materials and/or organic laser devices.
